Europäisches Patentamt

European Patent Office

Office européen des brevets

(11) Veröffentlichungsnummer : **0 095 732**
**B1**

(12) **EUROPÄISCHE PATENTSCHRIFT**

(45) Veröffentlichungstag der Patentschrift :
13.03.85

(21) Anmeldenummer : 83105201.4

(22) Anmeldetag : 26.05.83

(51) Int. Cl.⁴ : **H 03 B 23/00, G 01 R 23/16**

(54) **Spektrumanalysator.**

(30) Priorität : 29.05.82 DE 3220462

(43) Veröffentlichungstag der Anmeldung :
07.12.83 Patentblatt 83/49

(45) Bekanntmachung des Hinweises auf die Patenterteilung : 13.03.85 Patentblatt 85/11

(84) Benannte Vertragsstaaten :
FR GB IT

(56) Entgegenhaltungen :
DE-A- 2 933 221
DE-C- 2 914 143
US-A- 4 253 152
Patent Abstracts of Japan

(73) Patentinhaber : **Rohde & Schwarz GmbH & Co. KG**
**Mühldorfstrasse 15**
**D-8000 München 80 (DE)**

(72) Erfinder : **Zirwick, Kurt**
**Landsbergerstrasse 22**
**D-8919 Greifenberg (DE)**

(74) Vertreter : **Graf, Walter**
**Sckellstrasse 1**
**D-8000 München 80 (DE)**

Jouve, 18, rue St-Denis, 75001 Paris, France

## Beschreibung

Die Erfindung betrifft einen Spektrumanalysator laut Oberbegriff des Hauptanspruches.

Ein Spektrumanalysator dieser Art ist bekannt (DE-C-29 14 143). Über den Frequenzsynthesizer können in der Rücklaufperiode der Wobbelspannung Frequenzmarken dargestellt werden.

Bei Spektrumanalysatoren dieser Art ist es oftmals wünschenswert, vorbestimmte Frequenzkomponenten des durch die Wobbelspannung gewobbelten spannungsgesteuerten Oszillators auf einen vorgegebenen Punkt der Frequenzkoordinate der Anzeigeeinrichtung exakt einzustellen. Zu diesem Zweck ist es bei einem Spektrumanalysator bekannt, einen zusätzlichen Quarzoszillator vorzusehen, der über einen Umschalter zu vorbestimmt wiederkehrenden Zeitpunkten anstelle des Eingangssignals anschaltbar ist (DE-A-27 20 896). Über eine Vergleichseinrichtung wird dann eine im Auswertezweig des Analysators auftretende Spannung mit dem Momentanwert einer Sägezahnspannung verglichen und das Ergebnis wird einem Speicher zugeführt. Die gespeicherte Spannung wird dann in einem Summierglied der wieder angeschalteten Wobbelspannung überlagert. Diese bekannte Schaltung ist nicht sehr genau, da sie mit analogen Regelgrössen arbeitet und Frequenzfehler durch Regelreste zu befürchten sind. Ihre Anwendung ist auch durch den Fangbereich für die hierzu nötigen Regelschaltungen eingeengt.

Es ist an sich eine Schaltungsanordnung zur Erzeugung einer sich zwischen zwei Eckfrequenzwerten ändernden Ausgangsspannung bekannt (DE-A-29 33 221), bei welcher diese Eckfrequenzen durch einen Synthesizer vorbestimmt sind. Die Eckfrequenzwerte werden hierbei digital gespeichert und während des Wobbelvorganges wird die Frequenz des Oszillators ständig mit der Soll-Start- bzw. Soll-Stop-Frenquenz verglichen. Bei Frequenzgleichheit wird ein Schalter betätigt und dann der Ablauf der Sägezahnspannung umgekehrt. Diese bekannte Schaltung setzt voraus, dass der Synthesizer ständig die gewünschten Eckfrequenzwerte liefert, er könnte nicht zu anderen Zwecken beispielsweise zur Erzeugung von Frequenzmarken zusätzlich ausgenutzt werden. Die bekannte Schaltung ist daher relativ aufwendig. Die bekannte Schaltung besitzt ferner den Nachteil, dass der Frequenzhub durch die eingestellten Eckfrequenzwerte bestimmt ist. Auch die Genauigkeit ist nicht gross, da ein Frequenzvergleich oder Phasenvergleich zwischen zwei Wechselspannungen immer relativ ungenau ist.

Es ist Aufgabe der Erfindung, eine im Aufbau einfache Schaltung zum exakten Einstellen einer vorbestimmten Frequenzkomponente eines mittels einer Wobbelspannung gesteuerten Oszillators für einen Spektrumanalysator der zuerst erwähnten Art mit bereits vorhandenem Frequenzsynthesizer aufzuzeigen.

Diese Aufgabe wird ausgehend von einem Spektrumanalysator laut Oberbegriff des Hauptanspruches durch dessen kennzeichnende Merkmale gelöst. Vorteilhafte Weiterbildungen ergeben sich aus den Unteransprüchen.

Die erfindungsgemässe Schaltung baut auf auf einem bekannten Gerät zur Erzeugung von Frequenzmarken mittels eines Synthesizers, der in der Rücklaufperiode der Wobbelspannung unter Ausnutzung des Wobbeloszillators durch Aufbau einer entsprechenden Phasenregelschleife gebildet wird (DE-PS 29 14 143). Nach der Erfindung wird diese bekannte Schaltung zur Frequenzmarkenerzeugung nach dem Hauptanspruch so abgewandelt, dass die im Speicherglied gespeicherte Abstimmspannung, die während des Synthesizer-Betriebes erzeugt wurde, anschliessend unmittelbar zur Ansteuerung des Wobbeloszillators ausgenutzt werden kann und damit mit Quartzfrequenzgenauigkeit vorgegebene Punkte der Frequenzkoordinate der Anzeigeeinrichtung bestimmt. In einem Fall kann auf diese Weise beispielsweise der Beginn der Frequenzkoordinate auf dem Anzeigeschirm sehr genau festgelegt werden, indem einfach im Synthesizer-Betrieb dieser auf den Frequenzwert eingestellt wird, der dem Beginn des Wobbelhubes entspricht. Der Oszillator beginnt dann automatisch mit dieser Frequenz den Wobbelablauf. Eine andere Möglichkeit besteht darin, sowohl den Beginn als auch das Ende einer Spektraldarstellung eines Frequenzbandes durch die Synthesizereinstellung vorzugeben und die daraus resultierenden beiden unterschiedlichen Abstimmspannungen für Beginn und Ende in gesonderten Speichergliedern zu speichern. Damit kann ein Wobbeloszillator beispielsweise eines Panoramaempfängers zwischen zwei genau durch Synthesizereinstellungen fest vorgegebenen Frequenzwerten analog abgestimmt werden und für die Panoramadarstellung sind damit die Darstellungsbereichsgrenzen exakt vorgegeben. Eine solche Möglichkeit war bisher nur durch komplizierte analoge Steuerschaltungen möglich, beispielsweise durch entsprechende Lagenverschiebung und Pegelverschiebungen der Wobbelspannung von Hand. Mit der erfindungsgemässen Schaltung ist dies wesentlich einfacher und genauer möglich, die erfindungsgemässe Schaltung besitzt darüber hinaus noch den Vorteil, dass der eigentliche Empfangsteil, in welchem die entsprechende Wobbelspannungssteuerung durchgeführt werden muss, abgesetzt sein kann von einem den Wobbelvorgang steuernden Steuerteil, da bei der Erfindung nicht unbedingt Abstimmspannungen über Fernleitungen übertragen werden müssen sondern allenfalls entsprechende Startsignale, die dann automatisch im Empfangsteil die dort am Synthesizer eingestellten Spannungsabläufe auslösen.

Nach der Erfindung ist es ferner auf einfache Weise möglich, einen analog spannungsgesteuerten oder stromgesteuerten Wobbeloszillator frequenzmässig auf eine vorbestimmte Frequenz zu stabilisieren, also der analogen Wobbelspannung immer eine exakt vorwählbare Frequenz auf der Frequenzkoordinate der Anzeigeeinrichtung zuzuordnen. In diesem Fall ist es lediglich nötig, im Netzwerke die Wobbelspannung, die der Frequenzkoordinate der Anzeigeeinrichtung zugeführt wird, mit der im Speicherglied gespeicherten Abstimmspannung zu überlagern.

Die Erfindung wird im folgenden anhand schematischer Zeichnungen an Ausführungsbeispielen näher erläutert.

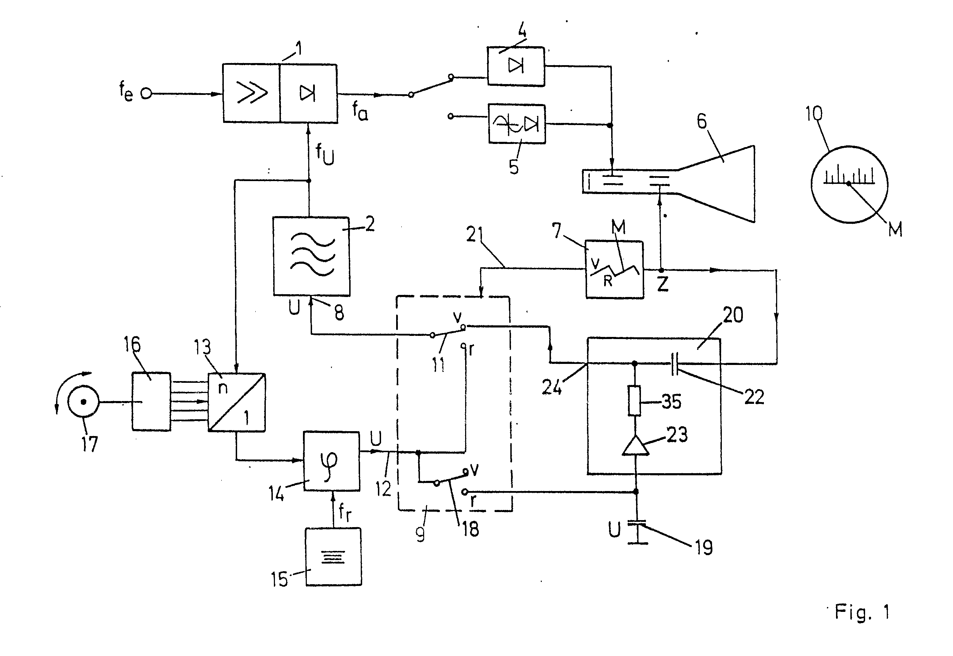

Fig. 1 zeigt das Prinzipschaltbild eines Spektrumanalysators mit einem Empfangsteil 1, in welchem die Empfangsfrequenz $f_e$ mit der Ausgangsfrequenz $f_u$ eines Wobbeloszillators 2 in eine zur Auswertung geeignete Zwischenfrequenz $f_a$ umgesetzt wird. Diese Zwischenfrequenz wird beispielsweise über verschiedene Demodulatorzweige 4 bzw. 5 dem vertikalen Ablenksystem einer Kathodenstrahlröhre 6 zugeführt. Das horizontale Ablenksystem dieser Kathodenstrahlröhre 6 ist mit einem Wobbelgenerator 7 verbunden, beispielsweise einem Sägezahngenerator, dessen Sägezahnspannung einen linearen Anstieg und linearen Abfall besitzt.

Der Wobbeloszillator 2 ist über seinen Steuereingang 8 in Abhängigkeit von einer angelegten Gleichspannung in seiner Ausgangsfrequenz abstimmbar. Zu seinem Betrieb als Wobbeloszillator kann der Steuereingang 8 unmittelbar mit dem Ausgang des Sägezahngenerators 7 verbunden werden.

Der Wobbeloszillator 2 kann in bekannter Weise als Oszillator in die Phasenregelschleife eines Frequenzsynthesizers eingeschaltet werden. Zu diesem Zweck ist beispielsweise ein Frequenzteiler 13 vorgesehen, dessen Teilungsfaktor durch einen als Zähler ausgebildeten Kodierer 16 mittels eines Einstellknopfes 17 digital einstellbar ist. Dem Frequenzteiler 13 wird eingangsseitig die Ausgangsfrequenz $f_u$ des Oszillators 2 zugeführt, die geteilte Ausgangsfrequenz wird einem Phasenvergleichsglied 14 zugeführt, dem ausserdem die Referenzfrequenz $f_r$ eines Quarzoszillators 15 zugeführt wird. Der Ausgang 12 des Phasenvergleichsgliedes 14 kann über einen Umschalter 9 mit dem Steuereingang 8 des Oszillators verbunden werden. In dem gezeigten Ausführungsbeispiel nach Fig. 1 besteht der Umschalter 9 aus einem ersten Schaltkontakt 11, der über die Steuerleitung 21 durch den Wobbelgenerator 7 so gesteuert ist, dass er in der Vorlaufperiode jeweils die Schaltstellung v und in der Rücklaufperiode jeweils die Schaltstellung r einnimmt. In der Rücklauf-Schaltstellung r ist also die Phasenregelschleife für den Synthesizer geschlossen. Zusätzlich ist noch ein zweiter synchron damit betätigter Schalter 18 vorgesehen, der in der Rücklaufphase die geschlossene Schaltstellung r einnimmt und der in der Vorlaufphase v offen ist. Der Schaltkontakt v des Schalters 11 ist mit dem Ausgang eines Netzwerkes 20 verbunden, der Kontakt r des Schalters 18 führt zu einem Speicherkondensator 19, der ebenfalls mit dem Netzwerk 20 verbunden ist. In dem Ausführungsbeispiel nach Fig. 1 dient das Netzwerk 20 zu Überlagern der Ausgangsspannung Z des Wobbeloszillators 7 mit der im Speicherkondensator 19 gespeicherten Spannung. Zu diesem Zweck umfasst das Netzwerk 20 einen Koppelkondensator 22, über den die symmetrische Sägezahnspannung Z zugeführt wird, dem anderen Ende des Kondensators wird über einen Trennverstärker 23 und einen Widerstand 35 die Ausgangsspannung U des Kondensators 19 als Mittelwertspannung unterlagert.

Nimmt bei der In Fig. 1 dargestellten Schaltung der Umschalter 9 mit seinen Einzelkontakten 11 und 18 die Schaltstellung r ein (Rücklaufperiode der Wobbelspannung), so ist die Phasenregelschleife geschlossen und bei Frequenz- und Phasengleichheit zwischen $f_r$ und der geteilten Ausgangsfrequenz $f_u$ liefert die Phasenvergleichseinrichtung 14 eine Abstimmspannung U für den Steuereingang 8 des Wobbeloszillators, die unmittelbar zugeordnet ist der am Einstellknopf 17 eingestellten gewünschten Ausgangsfrequenz $f_u$. Diese Abstimmspannung U wird in der Schaltstellung r nicht nur dem Steuereingang 8 des Oszillators 2 zugeführt sondern über den Kontakt 18 gleichzeitig auch dem Speicherkondensator 19 und wird dort gespeichert. Wenn der Umschalter 9 in die Schaltstellung v umgeschaltet wird, wird die Regelschleife 12 aufgetrennt und der Kondensator 19 von der Regelschleife 12 abgetrennt. Am Eingang des Netzwerkes 20 liegt die symmetrische Wobbelwechselspannung an. Diese Sägezahnspannung wird auf den Ausgang 24 des Netzwerkes 20 übertragen und gelangt über den Schalter 11 zum Steuereingang 8 des Oszillators 2. Die angelieferte Wechselspannung Z ist symmetrisch zu ihrem arithmetischen Mittelwert, der, nach Trennung durch den Koppelkondensator 22, durch die Abstimmspannung U gebildet wird. Daraus ergibt sich, dass die Mitte M der Sägezahnspannung am Wobbeloszillator 2 immer die Frequenz einstellt, die über den Synthesizer zur Abstimmspannung U geführt hat. Der Oszillator 2 wird also um eine genau durch die Synthesizereinstellung definierte Mittenfrequenz gewobbelt, die, wenn gleichzeitig die Wobbelspannung Z als x-Ablenkspannung für die Bildröhre 6 benutzt wird, immer der Bildmitte M des Schirmbildes 10 zugeordnet ist.

Die vom Netzwerk 20 gelieferte Abstimmspannung für den Oszillator 2 kann durch entsprechende Ausgestaltung des Netzwerkes 20 auf verschiedene Bezugspunkte der Frequenzkoordinate eingestellt werden, es kann also nicht nur auf die Bildmitte eingestellt werden sondern es ist auch möglich, jeden anderen Punkt der Frequenzkoordinate des Schirmbildes 10 durch entsprechende Einstellung des Synthesizers genau vorzubestimmen, die Abstimmspannung U der Synthesizereinstellung bestimmt immer die Bezugsfrequenz für die dem Netzwerk 20 von aussen zugeführte Wobbelspannung, wobei Letztere einen beliebigen periodischen Verlauf haben kann.

Es gibt Phasenvergleichsglieder 14, die von sich aus schon entsprechende Speicherkondensatoren eingebaut haben, also die einmal eingestellte Abstimmspannung halten. In diesem Fall kann ein gesonderter Speicherkondensator 19 entfallen, es muss nur dafür gesorgt werden, dass die Regelschleife so aufgetrennt werden kann, dass der gespeicherte Abstimmwert gehalten wird und im Sinne der Erfindung weiter für die Oszillatorabstimmung benutzt werden kann.

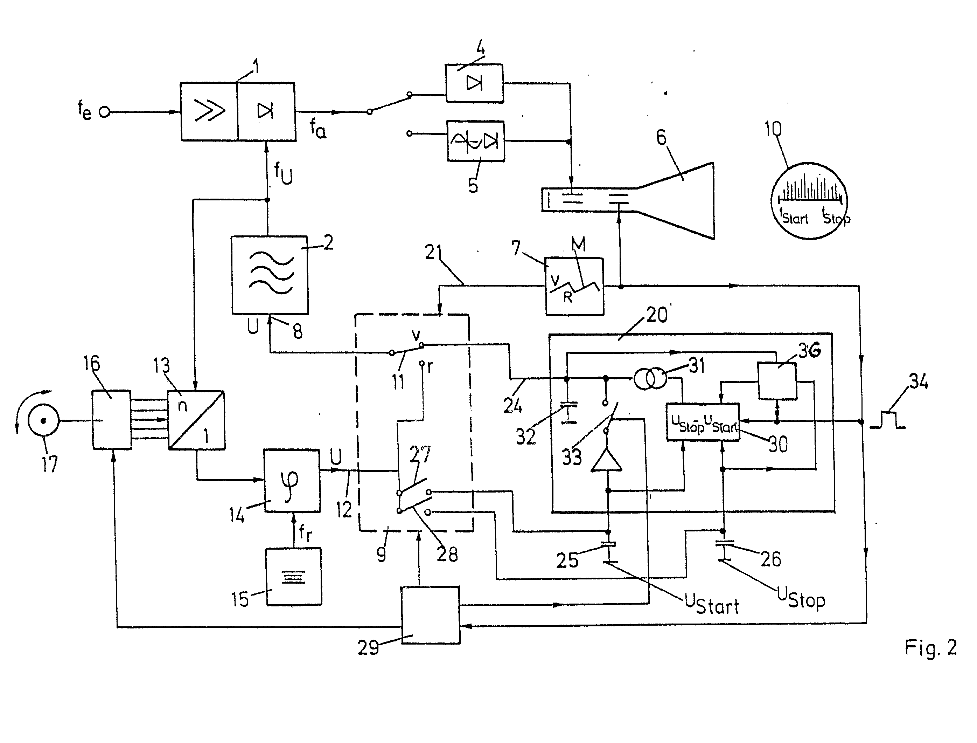

Fig. 2 zeigt eine andere Anwendungsmöglichkeit für die erfindungsgemässe Schaltung. Sie dient hier dazu, eine periodische analoge Abstimmung des Wobbeloszillators 2 zwischen zwei festen vorgegebenen Frequenzwerten festzulegen (Start und Stop beispielsweise einer Spektrumsdarstellung). Zu diesem Zweck sind dem Netzwerk 20 zwei gesonderte Speicherkondensatoren 25, 26 zugeordnet, die über getrennte Umschalter 27, 28 mit dem Ausgang 12 des Phasenvergleichsgliedes 14 verbindbar sind. Der Synthesizer 13, 16 wird in bekannter Weise nacheinander auf die gewünschten Start- und Stop-Frequenzen $f_{start}$ bzw. $f_{stop}$ eingestellt. Dies kann z. B. während des Rücklaufes der Darstellung geschehen. Zu diesem Zweck wird der Synthesizer 16 über die zusätzliche zentrale Steuerschaltung 29 entsprechend in Abhängigkeit vom Wobbelgenerator 7 angesteuert. Der Schalter 11 ist in dieser Phase in der Schaltstellung r und die Phasenregelschleife ist also wieder geschlossen. Die Schalter 27 und 28 werden ebenfalls über die zentrale Steuerschaltung 29 so gesteuert, dass diese nacheinander geschlossen werden. Der Schalter 27 wird also beispielsweise dann geschlossen, wenn am Synthesizer die Frequenz $f_{start}$ eingestellt wird. Damit wird automatisch im Kondensator 25 auch diejenige Abstimmspannung $U_{start}$ gespeichert, die dieser Startfrequenz entspricht. Wird während des gleichen Rücklaufes oder während einer nächstfolgenden Rücklaufperiode dann der Synthesizer auf die Stopfrequenz $f_{stop}$ abgestimmt, so wird gleichzeitig der Schalter 27 geöffnet und dafür der Schalter 28 geschlossen, so dass im Kondensator 26 schliesslich die der Stopfrequenz entsprechende Abstimmspannung $U_{stop}$ gespeichert ist. Im Netzwerk 20 ist eine Schaltung 30 vorgesehen, die einen Stromgenerator 31 so in Abhängigkeit von den zugeführten Spannungen $U_{start}$ und $U_{stop}$ steuert, dass der Stromgenerator an den Ausgang 24 und den Speicherkondensator 32 jeweils einen Strom liefert, der unmittelbar proportional ist der Differenz zwischen den beiden Spannungen $U_{start}$ und $U_{stop}$, und zwar in einer vorgegebenen Zeit, die beispielsweise der Hinlaufphase des Wobbeloszillators 7 entspricht. Der Stromgenerator 31 erzeugt also am Kondensator 32 einen Spannungshub von der Grösse $U_{stop}-U_{start}$ innerhalb dieser vorgegebenen Zeit. Der Kondensator 25 ist bei geschlossenem Schalter 33, der ebenfalls in Abhängigkeit von der zentralen Steuerschaltung 29 gesteuert ist, ebenfalls über einen Trennverstärker mit dem Ausgang 24 verbunden.

Trifft bei Beginn der Vorlaufperiode des Wobbeloszillators 7 am Eingang des Netzwertes 20 ein entsprechender Schaltimpuls 34 ein, so wird der Schalter 33 gleichzeitig geöffnet und es wird damit beginnend mit der am Ausgang 24 anliegenden Spannung $U_{start}$, die Spannung am Kondensator 32 proportional über den Stromgenerator 31 erhöht, bis schliesslich nach der vorgegebenen Zeit, also am Ende der Hinlaufphase, der Wert $U_{stop}$ erreicht ist. Damit sind die Frequenzgrenzen der Frequenzkoordinate auf der Schirmbilddarstellung 10 exakt durch die vorhergehende Synthesizereinstellung vorgegeben. Diese Voreinstellung der Grenzen kann automatisch wiederholt werden, was durch entsprechende Ansteuerung der zentralen Steuerschaltung 29 geschehen kann, die Grenzen können genauso leicht von Hand durch den Benutzer durch entsprechende Einstellung des Synthesizers geändert werden.

Das Netzwerk 20 umfasst noch eine Vergleichsschaltung 36, in welcher die Abweichung der am Ausgang 24 erzeugten Steuerspannung von der im Speicher 26 gespeicherten Stopspannung $U_{stop}$ laufend gemessen wird. Die Vergleichsschaltung 36 steuert die Schaltung 30 und es werden so eventuelle Abweichungen in der nächsten Vorlaufphase korrigiert.

Die in Fig. 2 dargestellte Vorgabe von genauen Frequenzgrenzen kann durch entsprechende mehrfache an- und abschaltbare Speicherkondensatoren auch für mehrere getrennte Spektraldarstellungszeilen mehrfach angewendet werden. Ausserdem ist es möglich, durch drei oder mehrere gesondert anschaltbare Speicherkondensatoren in einer Darstellungszeile verschiedene Darstellungsabschnitte mit verschiedener Ablaufgeschwindigkeit einzustellen, wesentlich ist, dass mit dem Synthesizer verschiedene vorbestimmte Punkte der Frequenzdarstellung auf dem Bildschirm genau vorbestimmt werden können und von diesen Punkten aus dann die verschiedenartigsten Steuerabläufe abgeleitet werden können. Natürlich kann über die gespeicherten Spannungswerte im Sinne der DE-C-29 14 143 auch wieder eine entsprechende Frequenzmarke gesetzt und über den Synthesizer eingestellt werden.

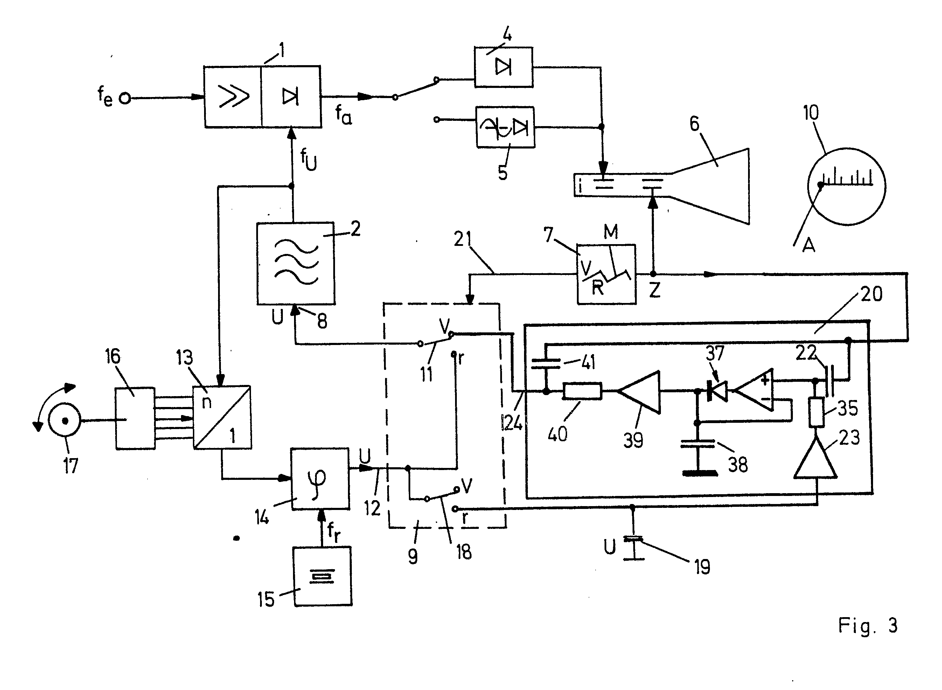

Fig. 3 zeigt eine Erweiterung der Schaltung nach Fig. 1, und zwar die Möglichkeit, wie durch Abänderung des Netzwerkes 20 die Frequenzkomponente des Oszillators 2 auf den Anfangspunkt A der Frequenzkoordinate eingestellt werden kann. In dem einen Teil des Netzwerkes 20 wird wieder genauso wie nach Fig. 1 über den Kondensator 22 die Sägezahnspannung Z der im Kondensator 19 als Mittelwert gespeicherten Ausgangsspannung U über den Trennverstärker 23 und den Widerstand 35 unterlagert. Die Sägezahnspannung Z pendelt also mit ihrem Scheitelwert symmetrisch um diesen Mittelwert U und wird einem Spitzenwertgleichrichter 37 bestehend aus einem Verstärker und einem Gleichrichter zugeführt. Der Kondensator 38 wird bei der dargestellten Polung des Gleichrichters auf den Spannungswert « U + Scheitelwert Z » aufgeladen. Diese Spannung wird über einen weiteren Trennverstärker 39 und einen Widerstand 40 der über den Kondensator 41 zugeführten Sägezahnspannung Z als Mittelwertspannung erneut unterlagert und am Ausgang 24 entsteht also eine Abstimmspannung für den Oszillator 2, die um diesen neu gewonnen Mittelwert symmetrisch um den Scheitelwert der Sägezahnspannung Z pendelt. Der niedrigste Spannungswert dieser so am Ausgang 24 gewonnenen Spannung entspricht dabei automatisch dem im Kondensator 19 gespeicherten Spannungswert U, d. h. es wird automatisch derjenige Punkt A der Frequenzkoordinate der Synthesizerfrequenz zugeordnet, welcher dem negativsten Wert der Sägezahnspannung Z zugeordnet ist, damit kann also über den Synthesizer automatisch der Anfangspunkt A exakt festgelegt werden. Bei entgegengesetzter Polung der Gleichrichterdiode 37 wird die maximale Grösse der Sägezahnspannung Z der eingestellten Synthesizerfrequenz zugeordnet, was bedeutet, dass damit der Endpunkt der Frequenzkoordinate der Anzeigeeinrichtung 10 der Synthesizerfrequenz zugeordnet ist.

In den vorhergehenden Ausführungsbeispielen ist der Übersichtlichkeit halber stets von einer Sägezahnspannung als Ablenkspannung und Wobbelspannung die Rede. Selbstverständlich ist die erfindungsgemässe Schaltung auch für jeden anderen beliebigen Funktionsverlauf dieser Ablenkspannung geeignet, die Ablenkspannung muss nicht linear ansteigen, es könnte genauso gut eine Sinusspannung sein.

**Ansprüche**

1. Spektrumanalysator mit einem spannungsgesteuerten Oszillator, der durch eine periodisch sich wiederholende Wobbelspannung, insbesondere eine linear ansteigende Sägezahnspannung, in der Frequenz durchstimmbar ist und mit dessen Ausgangsfrequenz ein Hochfrequenz-Eingangssignalband nach dem Überlagerungsprinzip in der Frequenz so umsetzbar ist, dass sämtlich in diesem Frequenzband auftretende Signale sequentiell auf dem Schirmbild einer Kathodenstrahlröhre spektrumartig darstellbar sind, und mit einem diesem Oszillator zugeordneten Umschalter, in dessen einer Schaltstellung der Oszillator in die Phasenregelschleife eines Frequenzsynthesizers eingeschaltet ist und die von dem Phasenvergleichsglied der Regelschleife gelieferte Abstimmspannung in einem Speicher gespeichert wird, und in dessen anderer Schaltstellung des Umschalters die Phasenregelschleife aufgetrennt und dafür eine Wobbelspannung an den Steuereingang des Oszillators angeschaltet ist, dadurch gekennzeichnet, dass zum exakten Einstellen einer vorbestimmten Frequenzkomponente des Oszillators (2) auf einen vorgegebenen Punkt (M, $f_{start}$, $f_{stop}$, A) der Frequenzkoordinate der Anzeigeeinrichtung (10) die Wobbelspannung in einem Netzwerk (20) erzeugt wird, welchem die im Speicher (19, 25, 26) gespeicherte Abstimmspannung (U, $U_{start}$, $U_{stop}$) so zugeführt ist, dass diese Abstimmspannung den vorgegebenen Punkt der Frequenzkoordinate bestimmt.

2. Spektrumanalysator nach Anspruch 1, dadurch gekennzeichnet, dass der Speicher zwei oder mehrere gesonderte Speicherglieder (25, 26) aufweist, die über den Umschalter (9, 27, 28) nacheinander an das Phasenvergleichsglied der Regelschleife (12) anschaltbar sind.

3. Spektrumanalysator nach Anspruch 1 oder 2, dadurch gekennzeichnet, dass die Wobbelspannung (Z) in dem Netzwerk (20) der im Speicher (19) gespeicherten Abstimmspannung (U) unterlagert wird (Fig. 1 und 3).

4. Spektrumanalysator nach Anspruch 3, dadurch gekennzeichnet, dass die unterlagerte Wobbel-Abstimm-Spannung (U + Z) in einem Spitzenwertgleichrichter (37) gleichgerichtet und dann erneut der Wobbelspannung (Z) unterlagert wird (Fig. 3).

5. Spektrumanalysator nach Anspruch 1 oder 2, dadurch gekennzeichnet, dass das Netzwerk (20) einen Generator (30) zum Erzeugen einer ansteigenden Wobbelspannung aufweist, über den Umschalter (9) zwei Speicherglieder (25, 26) nacheinander an das Phasenvergleichsglied (14) der Phasenregelschleife (12) anschaltbar sind und das Netzwerk (20) über einen vom Ablenkspannungsgenerator (7) erzeugten Schaltimpuls (34) so steuerbar ist, dass beim Eintreffen eines solchen Schaltimpulses (34) das Netzwerk (20) eine Wobbelspannung an den Steuereingang (8) des Oszillators (2) abgibt, die beginnend mit einem Spannungswert, welcher der im einen Speicherglied (25) gespeicherten Abstimmspannung ($U_{start}$) entspricht, bis zum Erreichen des Spannungswertes ansteigt, welcher der im anderen Speicherglied (26) gespeicherten Abstimmspannung ($U_{stop}$) entspricht (Fig. 2).

**Claims**

1. Spectrum analyzer comprising a voltage-controlled oscillator, whose frequency can be tuned with the aid of a periodically repeated sweep voltage, especially a linearly increasing sawtooth voltage, and whose output frequency serves for converting an RF input signal band according to the heterodyning principle such that all signals received in this frequency band can be displayed successively in the form of a spectrum on the screen of a CRT, and a switch associated to this oscillator which, in one position, cuts the oscillator into the phase-lock loop of a frequency synthesizer and causes the tuning voltage derived from the phase comparator of the phase-lock loop to be stored in a memory and, in the other position, interrupts the phase-lock loop and connects instead a sweep voltage to the control input of the oscillator, characterized in that, for exact adjustment of a predetermined frequency component of the oscillator (2) to a given point (M, $f_{start}$, $f_{stop}$, A) in the frequency coordinate of the display (10), the sweep voltage is generated in a network (20), to which the tuning voltage (U, $U_{start}$, $U_{stop}$) stored in the memory (19, 25, 26) is applied such that this tuning voltage determines the given point of the frequency coordinate.

2. Spectrum analyzer according to Claim 1 characterized in that the memory comprises two or more storage elements (25, 26) which can be connected successively to the phase comparator in the phase-lock loop (12) with swith (9, 27, 28).

3. Spectrum analyzer according to Claim 1 or 2, characterized in that the sweep voltage (Z) in the network (20) is underlaid the tuning voltage (U) stored in the memory (19). (Figs. 1 and 3).

4. Spectrum analyzer according to Claim 3 characterized in that the underlaid sweep tuning voltage (U + Z) is rectified in a peak rectifier (37) and then underlaid again the sweep voltage (Z) (Fig. 3).

5. Spectrum analyzer according to Claim 1 or 2 characterized in that the network (20) comprises a generator (30) for producing an increasing sweep voltage, that two storage elements (25, 26) can be connected successively to the phase comparator (14) of the phase-lock loop (12) with switch (9), and that the network (20) is controlled by a switching pulse (34) produced in the deflection voltage generator (7) such that upon arrival of such switching pulse (34) the network (20) applies a sweep voltage to the control input (8) of the oscillator (2), which rises, starting at a voltage corresponding to the tuning voltage ($U_{start}$) stored in the one storage element (25), until it reaches a voltage corresponding to the tuning voltage ($U_{stop}$) stored in the other storage element (26) (Fig. 2).

### Revendications

1. Analyseur de spectres avec un oscillateur commandé par tension qui, pendant une tension de balayage périodique qui recommence, en particulier une tension linéaire qui monte en dents de scie, est réglable en fréquence, et avec laquelle la fréquence de sortie est un signal d'entrée à haute fréquence suivant le principe de changement dans la fréquence qui est convertible de telle façon que tous les signaux séquentiels qui se présentent sur l'oscillateur d'un tube à rayons cathodiques analogues à un spectre peuvent être décrits, et avec un commutateur subordonné à cet oscillateur dans lequel une touche de l'oscillateur dans la phase de réglage d'un synthétiseur de fréquence est inséré et qui, du maillon de compensation de phases de la bouche de réglage à la tension de sortie est alimentée dans un magasin, et dans laquelle une autre touche de permutation se sépare de la bouche de phase de réglage et à cet effet une tension de balayage à l'entrée de l'oscillation est mise sous tension, caractérisé en ce que, pour une mise au point exactement d'un composant de fréquence de l'oscillateur (2) sur un point déterminé (M, $f_{start}$, $f_{stop}$, A) des coordonnées de fréquence d'installation (10), la tension de balayage est produite dans un réseau (20) auquel la tension de sortie emmagasinée (U, $U_{start}$, $U_{stop}$) est amenée de façon telle que cette tension de sortie détermine le point indiqué des coordonnées de fréquence.

2. Analyseur de spectre suivant la revendication 1, caractérisé en ce que le magasin présente deux ou plusieurs réservoirs indépendants (25, 26) qui sur les commutateurs (9, 27, 28) peuvent être mis sous tension les uns après les autres au maillon de compensation de phase de la boucle de réglage (12).

3. Analyseur de spectre suivant l'une des revendications 1 ou 2, caractérisé en que la tension de balayage (Z) dans le réseau (20) est sous-jacente à la tension de sortie emmagasinée dans le magasin (19). (Figures 1 et 3).

4. Analyseur de spectre suivant la revendication 3, caractérisé en ce que la tension de sortie emmagasinée (U + Z) est redressée dans un détecteur de valeur de crête (37) et la tension de balayage (Z) renouvelée et emmagasinée. (Figure 3).

5. Analyseur de spectre suivant l'une des revendications 1 ou 2, caractérisé en ce que le réseau (20) possède un montage (30) pour produire une tension de balayage qui augmente, deux condensateurs (25, 26) peuvent être mis sous tension l'un après l'autre sur le maillon de compensation de phase (14) de la boucle de réglage (12) et le réseau (20) peut être rendu utilisable par une impulsion (34) produite par le générateur de tension de déviation (7), de sorte que lors de la réalisation d'une telle impulsion (34) une tension de balayage à l'entrée (8) de l'oscillateur (2) est remise, qui en commençant par une valeur de tension correspondant à la tension ($U_{start}$) dans une réserve (25) jusqu'à l'atteinte de la valeur de tension qui monte et qui correspond à la tension ($U_{stop}$) alimentée dans l'autre réserve (26) (figure 2).

Fig. 1

Fig. 2

0 095 732

Fig. 3

0 095 732

3